# EUROPEAN PATENT APPLICATION

(11) **EP 3 609 044 A1**
(43) Date of publication of application: **12.02.2020**
(21) Application number: 18781845.5
(22) Date of filing: 08.04.2018
(51) Int. Cl.: H02J 7/00, H05K 1/02

(54) **CHARGING CIRCUIT AND CHARGING METHOD THEREOF**

(30) Priority: 07.04.2017 CN 201710225653
(71) Applicant: ZTE Corporation, Shenzhen, Guangdong 518057 (CN)
(72) Inventor: LONG, Yuqi, Shenzhen Guangdong 518057 (CN); HOU, Fangxi, Shenzhen Guangdong 518057 (CN); XIAO, Hua, Shenzhen Guangdong 518057 (CN)
(74) Representative: Hervouet-Malbec, Sylvie
(86) International application number: PCT/CN2018/082155
(87) International publication number: WO 2018/184592

(57) **Abstract**

A charging circuit provided in an embodiment of the disclosure includes: a universal serial bus USB interface, a main board, and a battery. The charging circuit also includes a first charging line for transmitting a current, a second charging line for transmitting a current, and a signal line for transmitting data signals. The USB interface is respectively connected to a first end of the first charging line, a first end of the second charging line, and a first end of the signal line; a second end of the first charging line and a second end of the second charging line are connected to the battery by means of the motherboard; and a second end of the signal line is connected to the motherboard. Also provided in the embodiments of the present application is a charging method for use in the present charging circuit.

## Description

### FIELD OF THE INVENTION

The present disclosure relates to the field of communications, and in particular, to a charging circuit and a charging method thereof.

### BACKGROUND

With the spread of the rapid charging technology, more and more electronic devices (e.g., mobile phones) support rapid charging. Rapid charging means that a large current flows through the electronic device, which may generate a large amount of heat. For a conventional design of mobile phone, a main board is generally located at an upper portion, a Universal Serial Bus (USB) charging interface is generally located at a lower portion, and a battery is located between the USB interface and the main board. Therefore, the charging loops must flow through the battery. In this case, the battery is susceptible to be influenced by the heat generated by the charging loops, and may even cause an explosion.

### SUMMARY

In view of the above, embodiments of the disclosure provide a charging circuit and a charging method applicable to the charging circuit.

In a first aspect, an embodiment of the disclosure provides a charging circuit, including: a universal serial bus USB interface, a main board and a battery. The charging circuit further includes a first charging line configured to transmit a current, a second charging line configured to transmit a current, and a signal line configured to transmit a data signal. The USB interface is connected to a first end of the first charging line, a first end of the second charging line and a first end of the signal line, respectively; a second end of the first charging line and a second end of the second charging line are connected to the battery through the main board; and a second end of the signal line is connected to the main board.

In a second aspect, an embodiment of the disclosure provides a charging method applicable to the above charging circuit, including a step of: under a condition that the USB interface is connected with a power source, transmitting a current input from the USB interface to the battery via the main board by the first charging line and the second charging line.

### BRIEF DESCRIPTION OF THE DRAWINGS

FIG. 1 is a schematic structural diagram of a charging circuit according to an embodiment of the disclosure;
FIG. 2 is a schematic layout diagram of a charging chip according to an embodiment of the disclosure;
FIG. 3 is a schematic structural diagram of a charging line according to an embodiment of the disclosure;
FIG. 4 is a schematic structural diagram of a conventional charging circuit;
FIGS.5(a) and 5(b) are schematic diagrams showing a comparison between the charging line according to the embodiment of the disclosure and the charging line of the conventional charging circuit;
FIG. 6 is a diagram illustrating a definition of a type C interface supporting USB 3.0 according to an embodiment of the disclosure; and
FIGS. 7(a) and 7(b) are schematic diagrams illustrating a comparison between a sub-board wiring according to an embodiment of the disclosure and a conventional sub-board wiring.

### DETAILED DESCRIPTION OF THE EMBODIMENTS

In embodiments of the present disclosure, a USB interface is connected to a first end of a first charging line, a first end of a second charging line, and a first end of a signal line, respectively; a second end of the first charging line and a second end of the second charging line are connected to the battery via a main board; and a second end of the signal line is connected to the main board. The first charging line is configured to transmit a current. The second charging line is configured to transmit a current. The signal line is configured to transmit a data signal.

The implementation of the technical solution will be described in detail below with reference to the accompanying drawings.

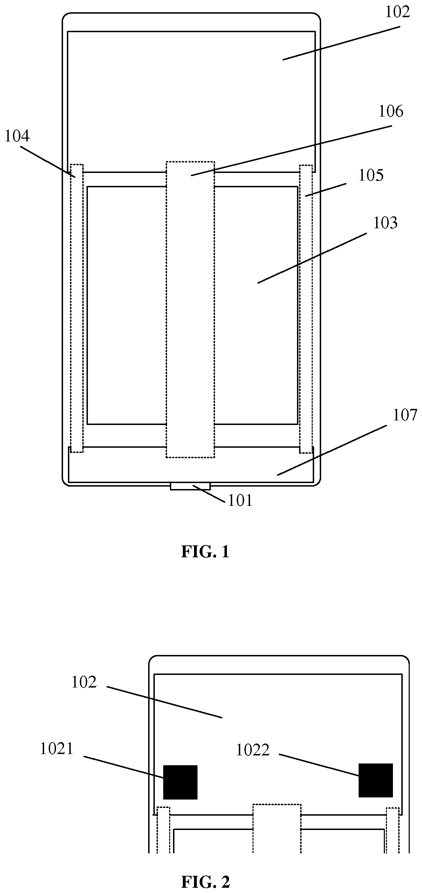

There is provided a charging circuit in an embodiment of the disclosure. As shown in FIG. 1, the charging circuit includes: a USB interface 101, a main board 102, a battery 103, a first charging line 104 for transmitting a current, a second charging line 105 for transmitting a current, and a signal line 106 for transmitting a data signal, wherein the USB interface 101 is connected to a first end of the first charging line 104, a first end of the second charging line 105 and a first end of the signal line 106, respectively; a second end of the first charging line 104 and a second end of the second charging line 105 are connected to the battery via the main board 102; and a second end of the signal line 106 is connected to the main board 102.

As shown in FIG. 1, the first charging line 104, the second charging line 105, and the signal line 106 may be connected to the USB interface 101 via the sub-board 107. In the embodiment of the disclosure, the connection of the first charging line 104, the second charging line 105 and the signal line 106 to the USB interface 101 is not limited. In an exemplary embodiment, the first charging line 104 and the second charging line 105 may be disposed on both sides of the signal line 106, respectively. In this way, the first charging line 104, the signal line 106, and the second charging line 105 are disposed sequentially between the main board and the USB interface.

In a practical application, the first charging line, the second charging line, and the signal line may be implemented using a flexible printed circuit (FPC). Alternatively, the first charging line, the second charging line and the signal line may be implemented using a direct charging line such as a copper core line with a sheath, an injection-molded copper line, a gold-silver line, or any other suitable lines. The embodiment of the disclosure herein will not limit the specific form of the lines.

In the embodiment of the disclosure, the second end of the first charging line 104 and the second end of the second charging line 105 are connected to the battery 103 via the main board 102.

As shown in FIG. 2, the second end of the first charging line 104 is connected to the battery 103 via a first charging chip 1021 on the main board 102, and the second end of the second charging line 105 is connected to the battery 103 via a second charging chip 1022 on the main board 102.

Herein, the first charging line 104 and the second charging line 105, which transmit the charging current, are connected to the battery via the charging chips 1021 and 1022 located on the main board 102, such that the charging current is transmitted to the battery through the charging chips 1021 and 1022 when the charging is performed. In a practical application, one or two charging chips may be provided on the main board 102. When a single charging chip is provided on the main board, the second end of the first charging line and the second end of the second charging line are connected to the charging chip so as to transmit the charging current to the battery via the charging chip. When two charging chips are provided on the main board, the second end of the first charging line 104 and the second end of the second charging line 105 are connected to the battery through different charging chips, respectively, and simultaneously transmit the charging current to the battery. At this time, the current flowing through each charging chip is equal to half of the sum of the charging currents. Therefore, the two charging chips can disperse the heat generated by the charging current.

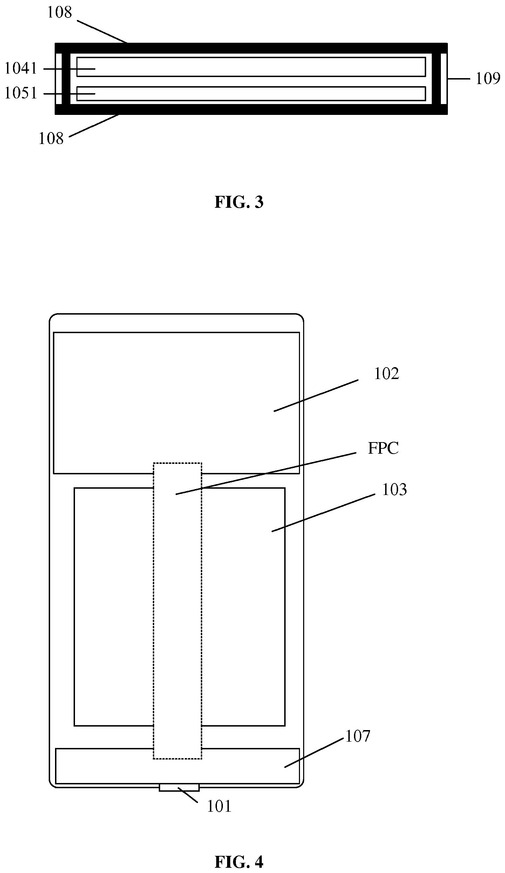

In the embodiment of the disclosure, as shown in FIG. 3, the first charging line 104 and the second charging line 105 include a first wiring layer 1041 and a second wiring layer 1042, respectively. Herein, a first end of the first wiring layer 1041 is connected to a USB power source interface (VBus) of the USB interface 101, and a second end of the first wiring layer 1041 is connected to the battery 103 through the main board 102. A first end of the second wiring layer 1051 is connected to a grounding interface of the USB interface 101, and a second end of the second wiring layer 1051 is connected to a grounding interface of the main board 102.

Herein, both ends of the first wiring layer 1041 are connected to the power source interface (VBus) of the USB interface 101 and the main board 102, respectively, wherein the end in connection with the main board 102 is connected to the battery 103 via the main board 102. Both ends of the second wiring layer 1051 are connected to the grounding interface of the USB interface 101 and the grounding interface of the main board 102, respectively, such that the charging lines including the first charging line 104 and the second charging line 105 are connected to the grounding interface of the main board 102 at a single point. As a result, the first charging line 104 and the second charging line 105 are connected to the main board 102. Thus, in the process of charging, the loop current of the second wiring layer 1051 is a current between the grounding interface of the main board 102 and the grounding interface of the USB interface 101, and the loop current and the charging current of the first wiring layer 1041 have equal amount and opposite direction. In the embodiment, as shown in FIG. 3, the first wiring layer 1041 and the second wiring layer 1051 form charging paths in parallel, such that the charging current is equal to a ground return current. Thus the electromagnetic fields generated whereby can be substantially offset each other.

It should be noted that, in the embodiment of the disclosure, the positions of the first wiring layer 1041 and the second wiring layer 1051 are not limited in any manners. The first wiring layer may be located above the second wiring layer or below the second wiring layer.

In the embodiment of the disclosure, the first charging line 104 has the same impedance with the second charging line 105, and the signal line 106 has impedance greater than the first charging line (or the second charging line). Here, the path for transmitting the charging current and the path for transmitting the data signal are separate from each other and implemented by different lines. Therefore, the charging FPC is more beneficial to current flowing, and the signal FPC has better impedance control. Therefore, the signal quality can be guaranteed at the time of rapid charging. It should be noted that the signal line 106 has impedance greater than the first charging line 104, and also greater than the second charging line 105. In other words, the signal line 106 has impedance different from the first charging line 104 (or the second charging line 105). Here, the signal line 106 and the first charging line 104 (or the second charging line 105) may utilize different laminated structures, i.e., a copper foil and a dielectric layer having different sizes, so as to achieve different impedances of the two lines.

In the embodiment of the disclosure, the charging circuit further includes a grounding structure 109; the first charging line 104, the second charging line 105 and the signal line 106 have a shielding layer 108, and the shielding layer 108 is connected with the grounding structure 109; the grounding structure 109 includes an antenna and/or a metal frame. In this way, the charging line and the communication signal can be shielded by the grounding structure 109 to minimize charging electromagnetic interference.

In the embodiment of the disclosure, the wiring of the charging circuit may include three lines (as shown by dotted lines in FIG. 1), two of which are the charging lines and one of which is the signal line. Here, the charging lines may be disposed on both sides of the signal line. In other words, the signal line is arranged between the two charging lines. The charging lines have impedance different from that of the signal line, such that the charging lines advantageously allow for current flowing, and meanwhile, the signal FPC has better impedance control. As such, the signal quality can be guaranteed at the time of the rapid charging. The grounding line of the charging FPC is connected to the grounding structure 109 at a single point on the side of the main board. The charging path adopts wiring in parallel, such that the charging current is equal to the grounding return current. Thus, the electromagnetic fields generated whereby can be substantially offset. In addition, all the charging lines and communication signals can be shielded by the grounding structure 109 to minimize the charging electromagnetic interference.

Based on the charging circuit, there is a charging method applicable to a charging circuit is provided in an embodiment of the disclosure. The method includes: when the USB interface is in connection with a power source, transmitting a current input from the USB interface to a battery via a main board through a first charging line and a second charging line. The method may further include: transmitting a data signal to the main board through a signal line. According to the embodiment of the disclosure, the transmission of the charging current from the USB interface to the battery can be completed through the first charging line and the second charging line, and the transmission of the data signal from the USB interface to the main board can be completed through the signal line. When the data signal is transmitted to the main board, the processing of the data signal can be completed through the processing of the main board, and an operation corresponding to the data signal can be performed.

Here, the USB interface is connected to the first end of the first charging line, the first end of the second charging lined, and the first end of the signal line, respectively; the second end of the first charging line and the second end of the second charging line are connected to the battery through the main board; the second end of the signal line is connected with the main board. The first charging line, the second charging line and the signal line are connected between the main board and the USB interface, and the first charging line and the second charging line are connected to the battery via the main board.

The first charging line and the second charging line include a first wiring layer and a second wiring layer, respectively. The current flowing through the first wiring layer and the current flowing through the second wiring layer have equal amount and opposite direction. Specifically, the current flowing through the first charging line or the second charging line includes a charging backflow from the main board to the USB interface, in addition to the charging current for charging the battery through the USB interface. The charging current is transmitted in the first wiring layer, and the charging backflow is transmitted in the second wiring layer, wherein, the charging current and the charging backflow have equal amount and opposite direction.

In addition, the second end of the first charging line is connected to the battery through the first charging chip on the main board, and the second end of the second charging line is connected to the battery through the second charging chip on the main board. When charging the battery through two charging chips on the main board, the current of the first charging line is transmitted to the battery through the first charging chip on the main board, and the current of the second charging line is transmitted to the battery through the second charging chip on the main board, wherein the current in the first charging line is equal to the current in the second charging line.

Here, the first charging line is connected to the battery through the first charging chip, and the second charging line is connected to the battery through the second charging chip. In this way, the charging current input from the USB interface is transmitted to the battery through two parallel lines to charge the battery.

In this embodiment, the USB interface has a type C structure supporting USB 3.0, and the charging lines and the signal line are FPC.

In the conventional charging circuit shown in FIG. 4, the USB interface 101 and the main board 102 are connected by a single FPC while the main board 102 is connected to the battery 103. On one hand, when the battery 103 is charged, the current of VBUS is concentrated on a FPC such that the heat is also gathered on the FPC. When charging with a large current, the heat generated by the FPC may heat the battery. After a period of time, the performance of the battery may deteriorate, even causing explosion. On the other hand, the charging return path may include a cable of an antenna, a magnesium-aluminum alloy frame, and an FPC. In accordance with the change of the contact resistance generated by the connector between the FPC and the sub-board 107, the distributed return current may generate an electromagnetic field, thereby interfering with the communication signal and the GPS signal of the mobile phone. Especially, the geomagnetic sensor is most affected. In addition, the Vbus signal and the USB 3.0 signal for charging are on the same FPC. In this manner, based on Vbus, a relatively thick copper foil layer is required for the current flow, while the signals of USB 3.0 and USB 2.0 require impedance control. Therefore, it is difficult to satisfy both requirements of Vbus and signal. Further, since the Vbus charging current generates an electromagnetic field, the signal of USB 3.0 may be affected when charging using the USB interface of a computer.

It should be noted that the FPC and the sub-board are connected to each other through the connector, and the contact resistance can be generated when the male socket and the female socket of the connector are connected to each other.

In the embodiment of the disclosure, the charging circuit as shown in FIG. 1 includes two FPCs for charging, and a FPC for transmitting signals. The FPC for charging and the FPC for transmitting signals may employ two kinds of laminated structures. The FPCs for charging are more conducive to current flowing, while the FPC for signal has better impedance control. In this way, the signal quality can be guaranteed at the time of rapid charging. The grounding of the FPC for charging is connected to the grounding of the main board at a single point on the side of the main board. The charging path adopts wiring in parallel, such that the charging current is equal to the grounding return current. Thus, the electromagnetic fields generated by whereby can be substantially offset. In addition, all the charging lines and communication signals can be shielded by the grounding structure to minimize the charging electromagnetic interference. Here, the grounding structure includes a main board grounding line, a grounding line formed of an antenna cable, and a grounding line formed of a magnesium-aluminum alloy frame.

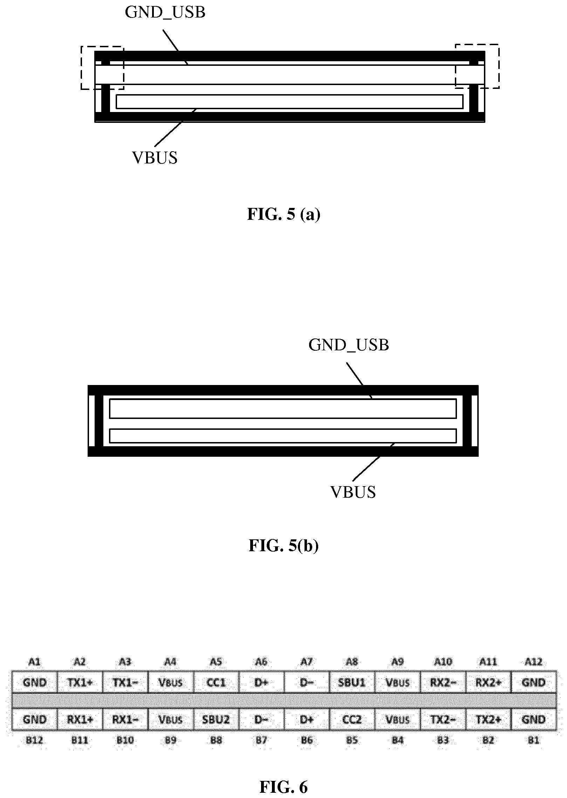

In this embodiment, the left charging FPC (the first charging line) and the right charging FPC (the second charging line) are a double-layer FPC including two wiring layers, wherein one layer is a Vbus layer in connection with the Vbus interface of the USB to transmit a charging current; the other layer is a GND_USB layer in connection with a grounding interface GND_USB of USB to transmit charging backflow. The GND_USB layer is a layer drawn from a type C connector supporting USB 3.0. The two charging FPCs have the same width and thickness of the copper foil. A shielding layer 108 connected to a grounding structure 109 is provided outside the FPCs. FIG. 5 (a) shows a cross section of a conventional charging FPC. FIG. 5 (b) shows a cross section of a charging FPC according to an embodiment of the disclosure. In FIG. 5 (a), the GND_USB layer is connected together with the grounding structure (as indicated by the dashed box). At this time, the charging backflow flows through a plurality of paths (including the cable of the antenna, the magnesium-aluminum alloy frame, and the FPC), and the charging current and the charging backflow flowing through the charging FPC are different from each other. Thus, there is a magnetic field that may interfere with the communication signal. In FIG. 5 (b), the GND_USB layer is separated from the grounding structure and connected to the grounding line of the main board. In this manner, the current of the Vbus layer and the current of the GND_USB layer are equal, such that the magnetic fields generated by the current of the Vbus layer and the current of the GND_USB layer can be substantially offset.

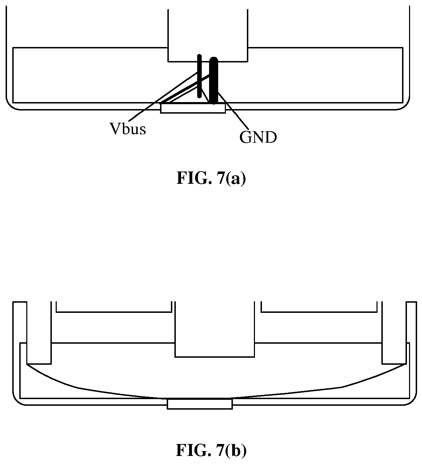

FIG. 6 illustrates a definition of a type C interface supporting USB 3.0. As shown in FIG. 6, the GND signals are distributed on both sides of the USB interface, and the Vbus signals are also distributed on both sides of the USB interface. Therefore, laminated wiring can be made on sub-board 107, such that the Vbus layer on the left side is connected to the Vbus interface of the USB interface 101, the GND_USB layer on the left side is connected to the GND interface on the left side, and the Vbus layer on the left side is connected to the GND connector on the left side. The left Vbus layer and the left GND_USB layer are enclosed by the shield layer 108 connected to the GND structure 109, and extended out of a left edge of the sub-board 107. The right Vbus layer and the right GND_USB layer are arranged in a similar manner. FIG. 7 (a) shows a conventional grounding manner in which there are cross wirings, and FIG. 7 (b) shows a wiring manner in which a charging line extends out of an edge of a sub-board according to an embodiment of the disclosure. Compared with the conventional grounding manner as shown in FIG. 7 (a), the charging circuit according to this embodiment will not affect wiring of the signal lines.

Here, when the main board employs two charging chips, the current flowing through each charging chip is equivalent to half of the sum of the charging current. In this case, the two charging FPCs are connected to two separate charging chips on the side of main board. In this way, the heat generated whereby cannot be concentrated.

The charging circuit and the charging method thereof according to the embodiments of the present disclosure have the following characteristics:
1. Separate charging currents, which can be separated on both sides of electronic equipment to disperse the heat, so as to minimize the possibility of battery explosion;
2. Charging in parallel, which ensures that magnetic fields generated by charging current and loop current can be substantially mutually offset, thereby effectively reducing electromagnetic interference; and
3. Separate wiring of charging and signal lines, which can guarantee the signal quality at the time of rapid charging.

It will be apparent to one skilled in the art that the embodiments of the disclosure may be provided as a method, a system, or a computer program product. Accordingly, the present disclosure may take the form of a hardware embodiment, a software embodiment, or a combination of software and hardware aspect embodiments. Described above are only the preferred embodiments of the disclosure, and are not intended to limit the scope of the disclosure.

## Claims

1. A charging circuit, comprising a universal serial bus USB interface, a main board and a battery, wherein
the charging circuit further includes a first charging line configured to transmit a current, a second charging line configured to transmit a current, and a signal line configured to transmit a data signal, and wherein
the USB interface is connected to a first end of the first charging line, a first end of the second charging line and a first end of the signal line, respectively; a second end of the first charging line and a second end of the second charging line are connected to the battery through the main board; and a second end of the signal line is connected to the main board.

2. The charging circuit according to claim 1, wherein
the second end of the first charging line is connected to the battery through a first charging chip on the main board, and the second end of the second charging line is connected to the battery through a second charging chip on the main board.

3. The circuit according to claim 1, wherein
the first charging line includes a first wiring layer, and the second charging line includes a second wiring layer.

4. The charging circuit according to claim 3, wherein
a first end of the first wiring layer is connected to a USB power source interface of the USB interface, and a second end of the first wiring layer is connected to the battery through the main board.

5. The charging circuit according to claim 3, wherein
a first end of the second wiring layer is connected to a grounding interface of the USB interface, and a second end of the second wiring layer is connected to a grounding interface of the main board.

6. The charging circuit according to claim 1, wherein
the first charging line and the second charging line have the same impedance, and the signal line has impedance greater than that of the first charging line.

7. The charging circuit according to claim 1, further comprising a grounding structure, wherein
the first charging line, the second charging line, and the signal line have a shielding layer, respectively, shielding layer being connected to the grounding structure, and
the grounding structure comprises an antenna and/or a metal frame.

8. A charging method, applicable to the charging circuit according to claim 1, comprising a step of:
under a condition that the USB interface is connected with a power source, transmitting a current input from the USB interface to the battery via the main board by the first charging line and the second charging line.

9. The method according to claim 8, further comprising a step of:
transmitting a data signal to the main board through the signal line.

10. The method according to claim 8, wherein
the first charging line includes a first wiring layer, and the second charging line includes a second wiring layer, and wherein
the current of the first wiring layer and the current of the second wiring layer have equal amount and opposite direction.

11. The method according to claim 8, further comprising a step of:
transmitting the current of the first charging line to the battery through a first charging chip on the main board, and transmitting the current of the second charging line to the battery through a second charging chip on the main board, wherein the current in the first charging line is equal to the current in the second charging line.
